# EUROPÄISCHE PATENTSCHRIFT

(11) **EP 1 980 143 B1**
(45) Veröffentlichungstag und Bekanntmachung des Hinweises auf die Patenterteilung: **23.12.2009**
(21) Anmeldenummer: 07702783.7
(22) Anmeldetag: 16.01.2007
(51) Int. Cl.: H05K 3/32, H05K 3/22, H05K 1/02

(54) **LEITERPLATTE MIT ZUSÄTZLICHEN FUNKTIONALEN ELEMENTEN SOWIE HERSTELLVERFAHREN UND ANWENDUNG**
PRINTED CIRCUIT BOARD WITH ADDITIONAL FUNCTIONAL ELEMENTS, METHOD OF PRODUCTION AND USE
CARTE DE CIRCUITS IMPRIMÉS COMPORTANT DES ÉLÉMENTS FONCTIONNELS SUPPLÉMENTAIRES, SON PROCÉDÉ DE PRODUCTION ET SON UTILISATION

(30) Priorität: 31.01.2006 DE 102006004322
(43) Veröffentlichungstag der Anmeldung: 15.10.2008
(73) Patentinhaber: Häusermann GmbH, 3571 Gars am Kamp (AT)
(72) Erfinder: JANESCH, Rudolf, A-3571 Gars am Kamp (AT); STRUMMER, Erich, A-3571 Gars am Kamp (AT); HACKL, Johann, A-3571 Gars am Kamp (AT)
(74) Vertreter: Riebling, Peter
(86) Internationale Anmeldenummer: PCT/EP2007/000319
(87) Internationale Veröffentlichungsnummer: WO 2007/087982

(56) Entgegenhaltungen:
- EP-A1- 0 369 919
- WO-A-01/75964
- US-A- 5 493 076
- US-A- 6 062 903
- US-A1- 2004 246 662
- US-A1- 2005 253 233

## Beschreibung

Gegenstand der Erfindung ist eine Leiterplatte mit zusätzlichen funktionalen Elementen, bestehend aus runden oder rechteckigen elektrisch leitfähigen Verdrahtungselementen, also additiven Leitungsbahnen, die auf den beiden Oberflächen oder in einer inneren Lage einer Leiterplatte angeordnet sind. Neben einer üblicherweise feinstrukturierten Verdrahtung ist eine Integration sowohl von strombelastbaren Verdrahtungselementen als auch von thermisch gut leitfähigen flächigen Elementen oder flächigen gut biegbaren Elementen vorgesehen.

Übliche Leiterplatten werden mittels Ätztechnik, also mittels einer Subtraktivtechnik, hergestellt. Dabei begrenzt im Wesentlichen die jeweils verwendete Kupferfolienstärke von typisch 35 µm oder der halben beziehungsweise der doppelten Dicke und die Strukturbreite die Strombelastbarkeit der Leiterbahnen. Durch die Kombination einer herkömmlichen, ätztechnisch strukturierten Verdrahtungsebene mit üblicherweise wenigen additiven Verdrahtungselementen kann eine sehr kostengünstig herstellbare, multifunktionale Leiterplatte gestaltet werden, die zusätzlich zu der üblicherweise komplexen Schaltungslogik eine entsprechend stromführende Verdrahtung integriert.

Moderne komplexe Standard- und Feinleiterplatten bis zu Feinstleiterplatten werden nach dem Stand der Technik subtraktiv mittels Ätztechnik hergestellt, wobei nachfolgende chemische beziehungsweise galvanische Prozesse Durchkontaktierungen beziehungsweise die Verstärkung von leitenden Strukturen bewirken können. Dabei wird ein kupferkaschiertes oder auch aluminiumkaschiertes Substrat fotolithografisch oder per Siebdruck maskiert und diese Maske wird derart gehärtet, dass mittels Ätzchemikalien die Leiterstruktur hergestellt werden kann. Anschließend wird die sogenannte Ätzmaske gestrippt.

Alternativ werden additive Strukturierungstechniken in Form der Aufbringung elektrisch leitfähiger Pasten mittels Siebdruck verwendet. Auch InkJet- und Laser- basierende Additivtechniken sind möglich, allerdings nur bedingt einsetzbar, da nur in Spezialfällen eine Kostenkompatibilität gegenüber herkömmlicher Ätztechnik gegeben ist und überdies die technischen erzielbaren Parameter wesentlich ungünstiger sind.

Bei einer üblichen Leiterplattentechnik werden kupferkaschierte Substrate mit einer Kupferstärke von typisch 36 µm oder der halben oder doppelten Dicke verwendet. Oftmals wird auch eine galvanische Kupferabscheidung verwendet. Damit können sehr gut leitende Verdrahtungsstrukturen hergestellt werden.

Bei hochkomplexen Schaltungen werden Leiterbahnbreiten von unter 100 µm und Leiterbahnabstände von ebenfalls im Bereich 100 µm realisiert. Neben dieser hochkomplexen Verdrahtung werden jedoch bei bestimmten Applikationen im Automobilbereich oder in der Industrieelektronik und dergleichen Industriezweigen Verdrahtungselemente gewünscht, die nicht nur Signale und Schaltströme leiten können, sondern auch Ströme mit mehreren Ampere bis zu einigen 50 und 100 Ampere und darüber leiten können. Für derartige Anforderungen werden dann einzelne Verdrahtungselemente aus Drähten oder Stanzteilen gefertigt oder es wird die sogenannte Dickkupfertechnik mit Platinen mit Kupferfolien bis zu 400 µm Dicke verwendet.

Die ätztechnische Strukturierung derartiger dicker Kupferfolien ist sehr aufwendig und kostenmäßig ineffizient, da doch der überwiegende Kupferanteil weg geätzt werden muss.

In der EP0100422681 wird ein Verfahren zur Herstellung von drahtgeschriebenen Leiterplatten durch partielles Einfüllen einer härtbaren Isoliermasse in eine oben offene Gießform genannt, was in der vorliegenden Erfindung in keiner Weise vonnöten ist.

In der W002067642A1 wird ein Verfahren zur Herstellung einer Multiwire-Leiterplatte genannt, bei dem auf einer Seite eines dünnen Flächenelementes aus elektrisch leitendem Material mittels voneinander beabstandeter Klebeflächen Leitungsdrähte definiert verlegt und an vorgegebenen Kontaktstellen des Flächenelementes elektrisch mittels Schweißen, Bonden, Löten, Leitkleben o.dgl. kontaktiert werden.

Auf den fixierten Leitungsdrähten wird ein mechanisches Stabilisierungselement in Form eines Prepregs oder in Form eines mittels Isolierfolie aufgebrachten, elektrisch leitenden oder isolierenden Flächenelementes vorgesehen. Das Flächenelement wird dabei von der anderen Seite her derart strukturiert, dass die Kontaktstellen vom übrigen Flächenelement getrennt werden.Es werden Leitungsdrähte mittels Klebeflächen definiert verlegt.

Bei der genannten Druckschrift besteht der Nachteil, dass die an sich rund profilierten Leitungsdrähte mit Hilfe einer Verschweißung oder einer Bondverbindung elektrisch leitfähig mit den übrigen Teilen der Leiterplatte verbunden sind. Damit besteht jedoch der Nachteil, dass ein relativ dünner und runder Drahtquerschnitt auf einer großflächigen, metallisierten Kupferplatte nur punktweise kontaktiert werden kann. Dies führt zu hohen Temperaturen an der Kontaktstelle und einer entsprechenden Wärmebelastung im Bereich der Leiterplatte, was zu Verwerfungen im Bereich der Kupferfolie und auch im Bereich der umliegenden KunststoffMaterialien führt.

Die Leiterplatte neigt deshalb zur Verwerfung an den genannten Kontaktstellen, und bei einer späteren fotolithografischen Bearbeitung der Platte ist eine ebene Oberfläche der Platte nicht mehr gegeben. Damit besteht der Nachteil, dass keine feinen Strukturen fehlerfrei auf die Oberfläche der Leiterplatte aufgebracht werden können. Damit wird die Ausschussquote sehr hoch.

Mit der Druckschrift EP 0 369 919 A1 wird eine multifunktionale Leiterplatte mit einer elektrisch leitfähigen Struktur offenbart, wobei ein Hochstrom führendes Element stückweise auf der elektrisch leitfähigen Struktur mittels Ultraschall mechanisch und elektrisch leitend befestigt ist und der Kontakt zwischen dem Element und der Struktur intermetallisch ausgebildet ist. Dieser Druckschrift ein funktionelles Element, welches als thermisches Kontaktelement für ein Bauteil ausgebildet ist, wobei ein stückweiser Kontakt zwischen dem Element und der Struktur flächig ausgebildet ist nicht zu entnehmen.

Mit der Druckschrift US 5 493 076 A wird eine reparierte Struktur offenbart, welche mindestens eine elektrische Verbindungslinie aufweist, die eine Diskontinuität ausbildet, wobei diese elektrische Unterbrechung durch ein elektrisches Verbindungselement (leitfähiger Draht oder lsolationsbeschichtung) durch Herstellung einer Furche beseitigt wird.

Mit der Druckschrift US25253233 A1 wird eine bestückte Leiterplatte, welche mit Halbleiterbauteilen bestückt ist, wobei die Verbindung als Drahtbondkontaktierung ausgebildet ist.

Aufgabe der vorliegenden Erfindung ist die kostengünstige Herstellung von multifunktionellen Leiterplatten zur Verdrahtung von hochkomplexen Leiterstrukturen, insbesondere Fein- bis Feinstleiterstrukturen, gemeinsam mit Strukturen zur Leitung relativ hoher Ströme auf einer Platine.

Dieses Ziel wird durch die Merkmalskombinationen der unabhängigen Patentansprüche 1 und 12 erreicht.

Die Erfindung bezieht sich demnach auf eine Leiterplatte mit zusätzlichen funktionalen Elementen. Dabei wird eine hochkomplexe feine Struktur auf einer Leiterplatte mit der Möglichkeit der Verdrahtung von Hochstrom führenden Bauteilen auf einer Platine beschrieben.

Es wird weiters die Wärmeableitung durch die Ausbildung derartiger zusätzlicher Elemente auf und/oder in einer Leiterplatte beschrieben und deren Anwendung, für die Kontaktierung von Bauteilen zwecks Wärmeableitung.

In einer ersten Ausführungsvariante werden elektrisch leitfähige Verdrahtungselemente mittels Reibschweißverfahren oder Ultraschallschweißverfahren bevorzugt flächig auf eine darunter befindlichen ätztechnisch hergestellten Leiterstruktur befestigt und anschließen mittels entsprechender Harzsysteme einebnend bearbeitet.

In einer zweiten Ausführungsvariante werden elektrisch leitfähige Verdrahtungselemente mittels Reibschweißen beziehungsweise Ultraschall isolierend auf einem Leiterplattensubstrat befestigt. Dabei kann die Isolationsschicht vollflächig oder selektiv auf der entsprechenden Leiterplattenoberfläche angeordnet sein oder es kann das elektrisch leitfähige Verdrahtungselement auf der entsprechenden Seite oder umhüllend mit einem entsprechenden Harz versehen sein. Auf diese Weise wird eine eigenständige Verdrahtungsebene hergestellt. Die anschließende Einebnung mittels geeigneter Harzsysteme kann wie in der ersten Ausführungsvariante erfolgen.

In einer weiteren Ausbildung der vorliegenden Erfindung werden insbesondere flache Verdrahtungselemente als selektive wärmeableitende Elemente verwendet. Dabei sind flächige Elemente in eine Innenlage oder auf einer der beiden Oberflächen positioniert und es wird im Anschluss an die Einebnung beziehungsweise Lamination eine Öffnung derart hergestellt, dass der jeweilige Bauteil in direktem wärmeleitenden Kontakt montiert werden kann.

In einer weiteren Ausführungsform werden die bevorzugt flächigen Elemente auf beziehungsweise in einer Leiterplatte mit anschließender Einebnung angeordnet. Dieses zumindest eine flächige Element wird nach einem entsprechenden Fräs- oder Ritzvorgang mittels mechanischer Werkzeuge oder mittels Laser derart selektiv freigelegt, dass das Element im weitgehend freigelegten Bereich biegbar ist und eine semiflexible Leiterplatte beziehungsweise eine biegbare Leiterplatte gegeben ist.

Unter einem elektrisch leitfähigen Verdrahtungselement - beziehungsweise unter einem thermisch gut leitfähigen flächigen Element - beziehungsweise einem flächigen gut biegbaren Element - werden stückweise Elemente in Form von Runddraht oder Flachdraht verstanden, wobei als Material Kupfer oder Aluminium oder eine elektrisch gut leitfähige, biegbare und kontaktierbare Legierung verwendet werden kann.

Im Fall eines thermisch gut leitfähigen Elementes werden diese Materialien wie auch elektrisch isolierende Materialien verwendet. Im Fall der Verwendung dieses Elementes als Biegeelement können alle genannten Materialien und zusätzlich gut verarbeitbare, flächige Materialien verwendet werden, die ausreichend stabil für die jeweils geforderte Biegewechselzahl sind. Derartige Rund- oder Flachdrähte können überdies isolierend oder passivierend oder haftvermittelnd beschichtet ausgeführt werden.

Es wird damit ein kostengünstiges Verfahren zur Herstellung einer Leiterplatte mit zusätzlichen funktionalen Elementen beschrieben. Dabei werden insbesondere runde oder rechteckige elektrisch leitfähige Verdrahtungselemente oder thermisch gut leitfähige flächige Elemente oder flächige und gut biegbare Elemente mittels Reibschweißen oder Ultraschall oder Thermokompression auf eine oder beide Oberflächen und/oder in einer inneren Lage einer Leiterplatte angeordnet und es wird anschließend ein einebnender Prozess in Form einer Beschichtung und/oder einer Lamination ausgeführt.

Es wird die Anwendung einer derartigen Leiterplatte mit zusätzlichen funktionalen Elementen als multifunktionelle Leiterplatte beschrieben. Dabei wird sowohl die Integration einer hochkomplexen feinstrukturierten Leiterplatte mit der Möglichkeit der Verdrahtung von Hochstrom führenden Bauteilen in einer Platine als auch die Wärmeableitung durch die Ausbildung derartiger zusätzlicher Elemente auf und/oder in einer Leiterplatte beschrieben. Ferner wird die Anwendung derartiger zusätzlicher Elemente für die Herstellung von semiflexiblen bis starrflexiblen Leiterplatten beschrieben.

In einer Weiterbildung der Erfindung können die funktionellen Elemente als selektive wärmeableitende Elemente verwendet werden.

In der vorliegenden Erfindung wurde nunmehr gefunden, dass mit wenig aufwendigen Anlagen auf einer bereits ätztechnisch nach dem Stand der Technik hergestellten Kupferstruktur oder auf einer noch nicht geätzten Kupferfolie verstärkende Drähte oder rechteckförmige Bahnen, insbesondere in Form von Flachdrahtelementen, aufgebracht werden können. Dabei werden die ätztechnischen Strukturen oder die noch nicht geätzte Kupferoberfläche als Haftelemente verwendet und die zusätzlichen Elemente werden mittels Reibschweißen oder Ultraschall bevorzugt flächig elektrisch und thermisch gut leitend und natürlich mechanisch haftend kontaktiert. Dieser Vorgang wird bevorzugt flächig ausgeführt, da eine möglichst plane Oberfläche benötigt wird, um eine nachträgliche Einebnung durchführen zu können.

Grundsätzlich kann auch eine Kontaktierung mittels Strom erfolgen und es muss dabei sehr sorgfältig auf die Planität geachtet werden, da bei den relativ hohen Strömen punktuell hohe Temperaturen gegeben sind. Dadurch entstehen Thermospannungen die Verwölbungen erzeugen. Ein nachträglicher mechanischer oder thermomechanischer Prägevorgang kann jedoch auch hier Abhilfe schaffen.

Nach der rechnergestützten Verlegung dieser verstärkenden Elemente wird üblicherweise ein einebnender Prozess in Form eines Rakelprozesses oder eines Siebdruckprozesses oder eines Rollercoatingprozesses oder eines rechnergestützten Dispenserprozesse erfolgen. Der Einebnungsvorgang kann zusätzlich oder anstelle eines Laminiervorgangs realisiert werden. Dabei können entsprechend ausgebildete Prepregs oder konformierende verformbare und auch gegebenenfalls bereits strukturierte Lagen verwendet werden. Damit soll damit eine möglichst plane Oberfläche erzielt werden. Die Lamination erfolgt dabei typischerweise zwischen Pressblechen in einer Heiß-Kalt-Transferpresse mit oder ohne Vakuumunterstützung oder - weniger üblich - in einer Autoklavpresse.

Falls das zumindest eine zusätzliche, funktionale Element nur auf der Oberfläche einer Leiterplatte angebracht wird, kann der Laminationsprozess entfallen.

Erfindungsgemäß wurde nunmehr festgestellt, dass die Kontakte für derartige stromleitfähigen Elemente bestens durch die elektrisch leitfähige Struktur vorgegeben sind und durchaus geometrisch wesentlich breitere Kontaktflächen ausgebildet werden können. Dadurch ist eine sehr gute Kontaktierung der Leiterplatte gegeben. Die zusätzlichen funktionalen Elemente können überdies eine Art Überkreuzung von darunter befindlichen Leiterbahnen bewirken, wobei in diesen Fällen auf eine entsprechende Isolation geachtet werden muss.

In einer weiteren Ausbildung der vorliegenden Erfindung wurde festgestellt, dass derartige zusätzliche Elemente sehr gute wärmeleitfähige selektive Eigenschaften aufweisen und örtlich dort angebracht werden können, wo Komponenten befestigt werden sollen, die eine große Verlustleistung und eine große Wärme erzeugen. Das zusätzliche funktionale Element kann oberflächig auf der Leiterplatte angeordnet werden und die entsprechende Komponente kann dann direkt und gut wärmeleitend auf der Oberfläche dieses funktionalen Elementes angeordnet oder montiert werden.

Das funktionale Element kann jedoch ebenso im Inneren einer Leiterplatte angeordnet werden. In diesem Fall wird eine Kavität gefräst oder lasertechnisch oder ritztechnisch hergestellt und die entsprechende Komponente wird dann mit gutem thermischem Kontakt auf die frei gelegte Oberfläche dieses funktionalen Elementes montiert. Je nach Ausführungsform wird das funktionelle Element zumindest elementweise freigelegt und bedarf - im Falle von beispielsweise Kupfer - der Passivierung. Es muss darauf geachtet werden, dass diese Passivierung gute thermisch leitfähige Eigenschaften aufweist. Dies kann durch thermisch gut leitfähige Pasten erfolgen, wobei diese klebend oder lötbar oder lösbar ausgeführt sein können. Es kann auch eine chemische Oberflächenbehandlung oder eine bevorzugt bleifreie Heißluftverzinnung erfolgen.

Alle in den Unterlagen, einschließlich der Zusammenfassung offenbarten Angaben und Merkmale, insbesondere die in den Zeichnungen dargestellte Ausbildung, werden als erfindungswesentlich beansprucht, soweit sie einzeln oder in Kombination gegenüber dem Stand der Technik neu sind.

Die Erfindung wird nun anhand mehrerer Ausführungsbeispiele näher beschrieben. Hierbei gehen aus den Zeichnungen und ihrer Beschreibung weitere Vorteile und Merkmale hervor.

Dabei zeigen:
**Figur 1****:** eine schematische Darstellung einer erfindungsgemäßen multifunktionellen Leiterplatte (1) mit einem funktionellen Element (3) in einer einfachen Ausführungsform im Schnitt,
**Figur 2****:** eine schematische Darstellung einer erfindungsgemäßen multifunktionellen Leiterplatte (1) mit einem funktionellen Element (3) in einer Innenlage im Schnitt,
**Figur 3****:** eine schematische Darstellung einer erfindungsgemäßen multifunktionellen Leiterplatte (1) mit zwei funktionellen Elementen (3) im Schnitt,
**Figur 4a****:** eine schematische Darstellung einer erfindungsgemäßen multifunktionellen Leiterplatte (1) mit funktionellen Elementen (3, 22, 23) in Schrägansicht,
**Figur 4b****:** eine schematische Darstellung einer erfindungsgemäßen multifunktionellen Leiterplatte (1) mit funktionellen Elementen (3, 22, 23) in Draufsicht,
**Figur 5****:** eine schematische Darstellung einer erfindungsgemäßen multifunktionellen Leiterplatte (1) mit funktionellen Elementen (3, 22, 23) im Schnitt,
**Figur 6****:** eine schematische Darstellung einer erfindungsgemäßen multifunktionellen Leiterplatte (1) mit einem funktionellen Element (3) mit montiertem Bauteil (16) im Schnitt,
**Figur 7****:** eine schematische Darstellung einer erfindungsgemäßen multifunktionellen Leiterplatte (1) mit einem funktionellen Element (3) mit beidseitiger Kavität (15, 18) im Schnitt,
**Figur 8****:** eine schematische Darstellung einer erfindungsgemäßen multifunktionellen Leiterplatte (1) mit einem funktionellen Element (3) mit einseitiger Kavität (18) im Schnitt,
**Figur 9****:** eine schematische Darstellung einer erfindungsgemäßen multifunktionellen Leiterplatte (1) mit einem funktionellen Element (3) mit einem Bauteil (16) und einer Kavität (18) mit eingesetztem Kühlkörper (20) im Schnitt.

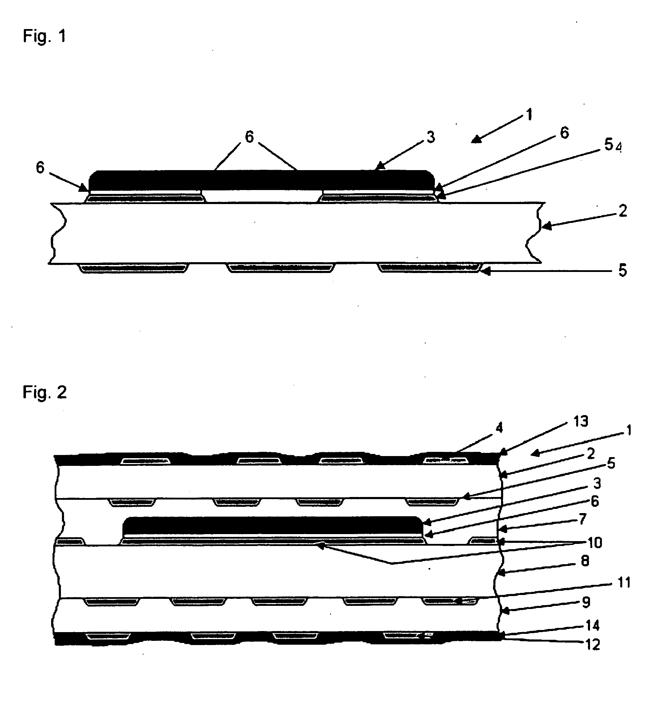

In **Figur 1** wird eine schematische Darstellung einer erfindungsgemäßen multifunktionellen Leiterplatte (1) mit einem funktionellen Element (3) in einer einfachen Ausführungsform im Schnitt aufgezeigt.

In dieser einfachen Ausführungsform wird ein Substrat (2) aus einem üblichen Leiterplattenmaterial wie FR-2, FR-3, FR-4, FR-4-Low-Tg, CEM-1, CEM-x, Pl, CE, Aramid und dergleichen Substratmaterialien mit beidseitig hergestellter Leiterbahnstruktur (4, 5) verwendet und ein funktionelles Element (3) wird flächig mittels Ultraschall beziehungsweise einem Reibschweißvorgang auf die zumindest zwei gezeichneten Leiterbahnstrukturen (4) kontaktiert.

In einer ersten Ausführungsform kann dabei das funktionelle Element (3) aus Kupfer oder Aluminium bestehen und es wird dabei üblicherweise mit der aus Kupfer bestehende Leiterbahnstruktur (4) eine intermetallische Verbindung hergestellt.

In weiteren Ausbildungen der vorliegenden Erfindung können die Oberflächen der Kontaktpaare (3, 4) chemisch oder galvanisch oder mittels Heißverzinnung (HAL) beschichtet sein. Bei entsprechender Materialpaarung wird bei einem üblichen Frequenzbereich von einigen kHz bis über 30 kHz Ultraschallenergie und bei entsprechender Sonotrodenausbildung und bei entsprechendem Anpressdruck eine flächige intermetallische Verbindung hergestellt.

Lediglich in einem wenige µm-Tiefe umfassenden Kontaktbereich wird eine für die Ausbildung des intermetallischen Kontaktes erforderliche hohe Temperatur erreicht und insgesamt erfährt das gesamte System örtlich keine große Erwärmung, sodass gegenüber Punktschweiß-Verbindungen nahezu keine Thermospannungen auftreten und die Verbindungspartner auch nach dem Verbindungsvorgang eine plane Lage aufweisen.

Bei Verwendung von lackisolierten, funktionellen Elementen (3) kann bei spezieller Ausbildung der Kontaktpartner (3, 4) und bei entsprechender Ausbildung der Lackschicht eine intermetallische Kontaktschicht (6) erreicht werden. Es können jedoch auch die Kontaktflächen mechanisch und/oder chemisch von einer allfälligen lsolationsschicht befreit werden. Dabei können Schleifverfahren, Bürstverfahren, Fräsverfahren oder ein Ätzverfahren oder ein Plasmaverfahren oder ein UV-Laserverfahren verwendet werden.

In der vorliegenden Figur 1 wird das funktionelle Element (3) als Verbindungselement zwischen zwei Elementen der Leiterbahnstruktur (4) dargestellt. Grundsätzlich können noch weitere Leiterbahnstrukturen (4) kontaktiert und/oder es können auch weitere Leiterbahnstrukturen (4) unterhalb des funktionellen Elementes (3) angeordnet werden. Dabei können derartige Elemente mit einer isolierenden, polymeren Schicht abgedeckt werden oder es kann das funktionelle Element (3) in Bereichen isolierend ausgebildet werden. Dadurch können Überkreuzungen ausgebildet werden.

In einer weiteren Ausbildung der Erfindung kann das funktionelle Element (3) als Stückelement mit der gewünschten geometrischen Abmessung verwendet oder es kann das Element (3) von einer Rolle zugeführt und gegebenenfalls durch eine geeignete Ausbildung der Sonotrode beim Kontaktiervorgang abgelängt werden.

Wahlweise kann im Anschluss an den Kontaktier- und Verlegevorgang noch ein Kalandriervorgang in Form von Kalander-Rollen oder einer Flachpressvorgang ausgeführt werden, sodass dadurch die Planlage bei kritischen Produkten erhöht wird.

In **Figur 2** ist eine schematische Darstellung einer erfindungsgemäßen multifunktionellen Leiterplatte (1) mit einem funktionellen Element (3) in einer Innenlage (7) im Schnitt aufgezeigt. Das Substrat (7) wird für die Einbettung beim Laminiervorgang verwendet, sodass eine weitgehend gleich dicke und ebene Leiterplatte (1) erreicht ist. In dieser Figur 2 wird lediglich ein funktionelles Element (3) über einem Element einer Verdrahtungsstruktur (10) mit der intermetallischen Verbindungsschicht (6) dargestellt. Ähnlich wie in Figur 1 schematisch dargestellt, kann das funktionelle Element (3) auch Leiterbahnstrukturen überkreuzen und es können Elemente (3) auch in den Substratebenen (2, 8, 9) beziehungsweise auf den Leiterbahnstrukturen (4, 5, 10, 11, 12) angeordnet sein. Die Kontaktierung derartiger funktionaler Elemente (3) kann über Durchsteigelöcher beziehungsweise Sacklöcher auf eine Kontaktfläche (4, 12) oder durch Freifräsung oder Laserung erfolgen.

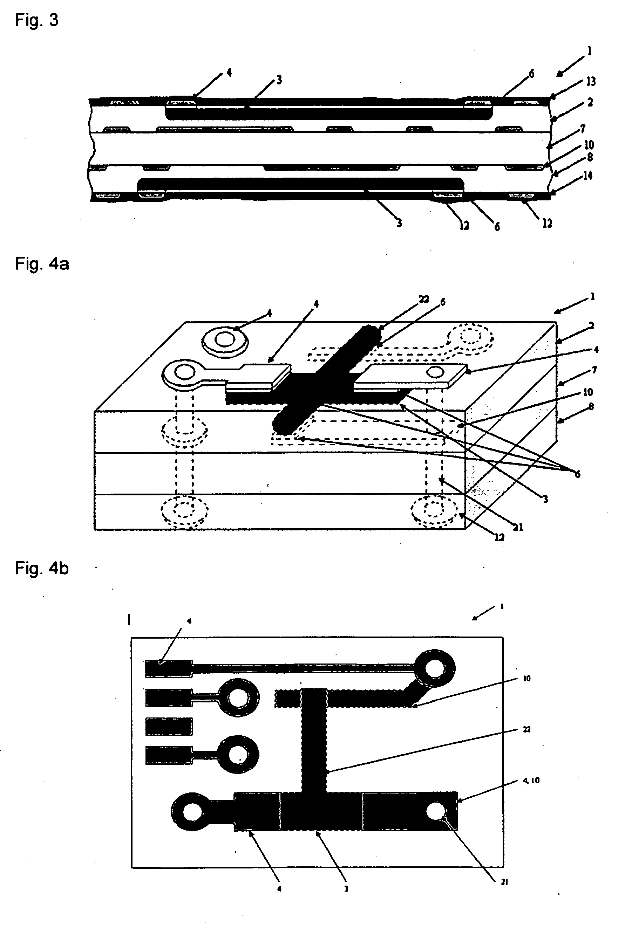

In **Figur 3** wird eine schematische Darstellung einer erfindungsgemäßen multifunktionellen Leiterplatte (1) mit zwei funktionellen Elementen (3) im Schnitt aufgezeigt. In dieser Mehrlagenleiterplatte (1) werden zwei funktionelle Elemente (3) dargestellt, die in die Substrate (2, 8) eingebettet sind. In dieser speziellen Ausführungsform werden die Elemente (3) auf die Rückseite einer Kupferfolie mittels Ultraschall beziehungsweise Reibschweißen kontaktiert.

Die Kupferfolien werden mittels Prepregs in einem Laminierprozess miteinander verpresst und anschließend mittels in der Leiterplattenindustrie üblicher Strukturierungsprozesse strukturiert. Dadurch werden die Leiterbahnstrukturen (4, 12) hergestellt, wobei innenliegend die Elemente (3) über intermetallische flächige Kontakte (6) angeordnet sind.

In diesem Verfahren werden die Elemente (3) nicht auf bereits strukturierte Leiterbahnelemente (4, 12) mittels Ultraschall beziehungsweise Reibschweißen kontaktiert, sondern auf vollflächige Kupferfolien, die nach dem Laminiervorgang mit isolierenden Zwischenlagen (Substraten (2, 8)) strukturiert werden. Zusätzlich wird in dieser Ausführung eine Kernlage (7) verwendet.

In **Figur 4a** wird eine schematische Darstellung einer erfindungsgemäßen multifunktionellen Leiterplatte (1) mit funktionellen Elementen (3, 22) in Schrägansicht aufgezeigt. In dieser Ausführungsvariante wird das funktionelle Element (3) - wie in Figur 3 beschrieben - innenliegend ausgeführt. Es wird also zunächst auf eine noch nicht strukturierte Kupferfolie mittels Ultraschall über intermetallische Flächen (6) kontaktiert und dann laminiert und anschließend strukturiert und so die Leiterbahnstrukturen (4) erzeugt.

In dieser Darstellung wird ein Durchsteigeloch (21) gezeigt, mit dem ein weiteres funktionelles Element (22) über eine Leiterbahnstruktur (10) kontaktiert und so mit der Struktur (4) verdrahtet wird.

In **Figur 4b** ist eine schematische Darstellung einer erfindungsgemäßen multifunktionellen Leiterplatte (1) mit funktionellen Elementen (3, 22) in Draufsicht aufgezeigt, wobei die strichliert gezeichneten Elemente (3, 10, 22) innenliegend sind. Das Element (3) wird üblicherweise bis zu den Anschlusskontaktflächen der Leiterbahnstruktur (4) geführt, da nur dadurch entsprechend hohe Ströme ohne wesentliche Erwärmung der elektrisch leitenden Verdrahtungsstrukturen möglich ist.

Es können jedoch auch dicke Elemente (3) mit lateral breiten Leiterbahnstrukturen (4) kombiniert werden, wobei der aktive Kupferquerschnitt für beide Strukturen (3, 4) ähnlich sein soll und so eine ähnlich gute Strombelastbarkeit gewährleistet ist.

Es handelt sich hierbei um eine innenliegende, elektrische Verbindung, die hohe Stromflüsse ermöglicht und kreuzend ausgeführt ist. Es kann daher der relativ hohe Stromfluss an verschiedene Stellen der Leiterplatte mit geringen Verlustleistungen und geringer Wärmebelastung geführt werden. Weil die sich kreuzenden, hoch stromführenden Leiterbahnabschnitte verdeckt und in Innenlagen eingebaut sind, sind sie gegen jegliche äußere Einflüsse geschützt und dadurch beschädigungsfrei verlegt.

Damit wird auf den anderen Ebenen, insbesondere den darüber liegenden Ebenen, Platz für eine Feinverdrahtung geschaffen, die andernfalls nicht möglich wäre.

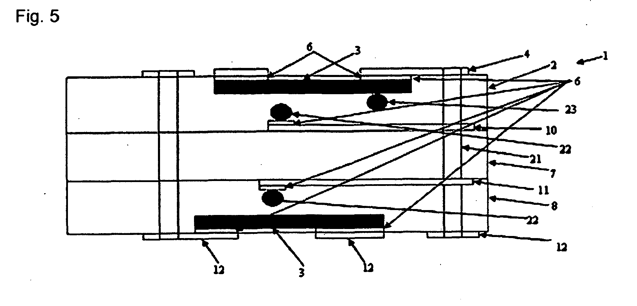

In **Figur 5** ist eine schematische Darstellung einer erfindungsgemäßen multifunktionellen Leiterplatte (1) mit funktionellen Elementen (3, 22, 23) im Schnitt gezeigt. In dieser Ansicht sollen die vielfältigen Anordnungsmöglichkeiten von funktionellen Elementen (3, 22, 23) dargestellt werden.

Hier sind in zwei Höhen versetzt zueinander angeordnete, in zusätzlichen Lagen angeordnete Elemente in Form von stromführenden Runddrähten 22, 23 verlegt. Die Runddrähte 22, 23 sind sich gegenseitig berührend, elektrisch leitfähig über eine intermetallische Verbindung verbunden.

Diese Elemente (22) sind über intermetallische Flächen (6) mit den Leiterbahnstrukturen (10, 11) und über ein Durchsteigeloch (21) mit den Leiterbahnstrukturen (4, 12) verbunden und so im oberen Bereich der Leiterplatte (1) über eine intermetallische Fläche (6) mit den funktionellen Elementen (3, 23) verbunden.

Man kann deshalb die Hochstrom führenden Elemente auch in mehreren voneinander getrennten Lagen im Leiterplattenaufbau führen. Dies ermöglicht eine hohe Komplexität des Leiterplattenaufbaus bei geringerer Anzahl von Lagen.

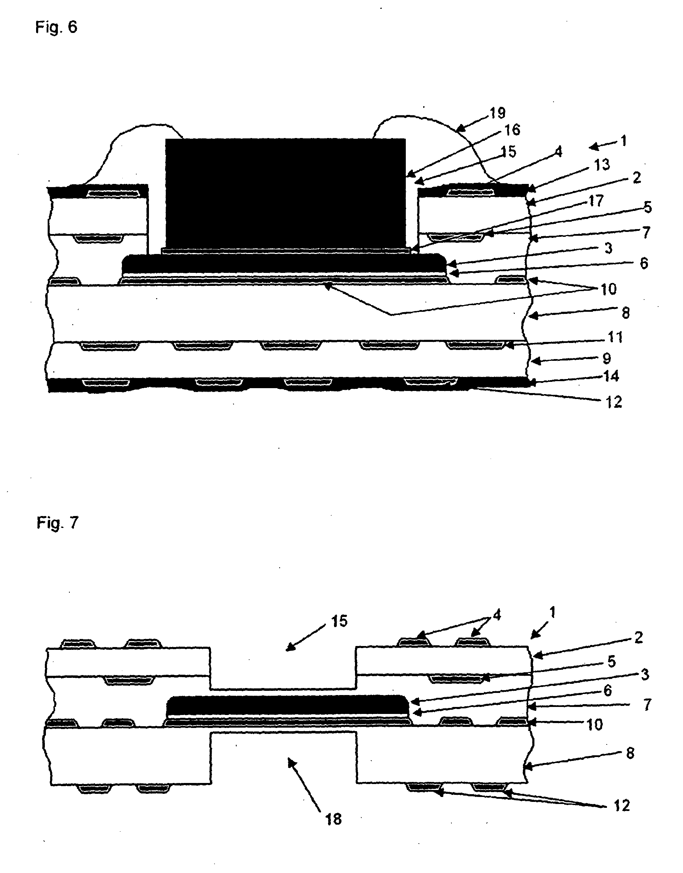

In **Figur 6** ist eine schematische Darstellung einer erfindungsgemäßen multifunktionellen Leiterplatte (1) mit einem funktionellen Element (3) mit montiertem Bauteil (16) im Schnitt aufgezeigt. In der Figur 6 ist die Kontaktierung eines Bauteils (16) über eine thermische Kontaktierfläche (17) mit der Oberfläche eines funktionellen Elementes (3) gezeigt.

Dabei wird in die Leiterplatte (1) eine Kavität (15) mittels Fräsen oder Laserung hergestellt. Im gezeichneten Fall wird die Kavität komplett bis zum Element (3) hergestellt. Sie kann jedoch auch nur stückweise hergestellt werden. Die thermisch gut leitfähige Kontaktierung (17) kann elektrisch leitfähig oder isolierend ausgebildet sein. Sie kann lösbar mittels thermischer Leitpasten hergestellt oder schwer lösbar mittels thermischem Leitkleber oder einer Lötpaste mittel Lötprozess hergestellt werden.

Die freigelegte Oberfläche des Elementes (3) kann auch mittels chemischer oder galvanischer Prozesse oder mittels Pasten oder mittels Heißluftverzinnung bedeckt werden und es kann dann das Bauteil (16) mit dem jeweils optimalen Kontaktierverfahren montiert werden.

Die elektrischen Anschlüsse des Bauteils (16) sind nicht eingezeichnet. Diese können mittels SMT (Surface-Mount-Technology) oder Drahtbondtechniken und dergleichen Technologien ausgeführt werden.

In dieser Ausbildung wird des Weiteren eine Vergussmasse (19) schematisch dargestellt, wobei die Vergussmasse (19) auch komplett über das Bauelement (16) angeordnet werden kann und im Falle einer optoelektronischen Funktion weitgehend transparent ausgeführt werden kann.

Das funktionelle Element (3) kann auch wesentlich größer ausgebildet sein als das Bauelement (16) und dadurch eine gute Wärmeabfuhr bewirken. Die Leiterplatte (1) wird in dieser Ausführung nach dem Stand der Technik mit einer Lötstoppmaske (13, 14) versehen.

In Figur 6 ist erkennbar, dass das funktionelle Element 3 eine Doppelfunktion hat: Einmal dient es zur Leitung von hohen Strömen, der über den gesamten Querschnitt dieses funktionellen Elements 3 geleitet wird und zum anderen dient es gleichzeitig sozusagen als innere Kühlfläche, die die Wärme dieses dort aufsitzenden Bauteils 16 besonders gut aufnimmt und verteilt.

In einer anderen Ausgestaltung dieser Ausführung kann es auch vorgesehen sein, dass dieses funktionelle Bauteil 3 nur und ausschließlich zur thermischen Aufnahme der Wärmeleistung des Bauteils 16 dient und keine zusätzliche Funktion der erhöhten Stromleitung ausübt.

In **Figur 7** ist eine schematische Darstellung einer erfindungsgemäßen multifunktionellen Leiterplatte (1) mit einem funktionellen Element (3) mit beidseitiger Kavität (15, 18) im Schnitt aufgezeigt.

In dieser Ausführung ist ein innenliegendes funktionelles Element (3) in der Substratlage (7) eingebettet, das über intermetallische Kontaktflächen (6) mit der Leiterbahnstrukturierung (10) verbunden ist. Von oben und von unten werden in diesem Fall Kavitäten (15,16) hergestellt. Grundsätzlich wird versucht, einen guten thermischen und/oder elektrischen Kontakt zu dem Element (3) herzustellen. Dies kann durch zumindest ein stückweises Freilegen der Oberflächen des Elementes (3) erfolgen. In der schematischen Figur 7 wird noch eine Bedeckung der Oberflächen des Elementes (3) dargestellt, was jedoch keine typische Ausführungsform ergibt.

Je nach Art der zu verwendenden Bauteile können diese auf die obere oder die untere Fläche des funktionellen Elementes (3) montiert werden und es kann zusätzlich oder alternativ ein Kühlkörperelement auf die entgegengesetzte Seite montiert werden. Grundsätzlich kann das Element (3) auch so groß gewählt werden, dass auf der gleichen Seite ein Kühlkörper montiert werden kann.

In dem gezeigten Ausführungsbeispiel dient das funktionelle Element 3 als starr-flexibles Biegeelement, welches einmalig oder mit wenigen Biegezyklen erlaubt, die beiden durch dieses funktionelle Element verbundenen Leiterplattenabschnitt im Winkel gegeneinander anzustellen und so zu belassen.

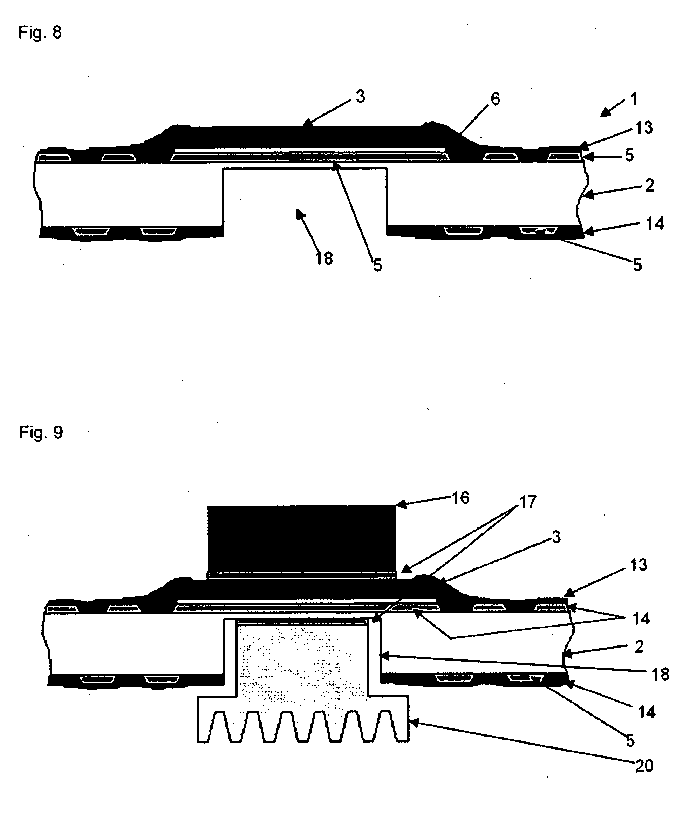

In **Figur 8** ist eine schematische Darstellung einer erfindungsgemäßen multifunktionellen Leiterplatte (1) mit einem funktionellen Element (3) mit einseitiger Kavität (18) im Schnitt aufgezeigt. Diese Ausführung mit der Kavität (18) stellt eine zweiseitige Leiterplatte (1) dar, wobei die Oberflächen mit Lötstoppmasken (13, 14) versehen sind. Die Kavität (18) wird üblicherweise bis auf die Oberfläche des Elementes (3) ausgebildet, so dass eine möglichst gute thermische Kontaktierung möglich ist.

In **Figur 9** ist eine schematische Darstellung einer erfindungsgemäßen multifunktionellen Leiterplatte (1) mit einem funktionellen Element (3) mit einem Bauteil (16) und einer Kavität (18) mit eingesetztem Kühlkörper (20) im Schnitt aufgezeigt.

In dieser Ausbildung sind ein Bauteil (16) und ein Kühlkörper (20) über eine thermische Kontaktierfläche (17) auf dem Element (3) befestigt. Grundsätzlich kann das Bauteil (16) auch in der Kavität (18) angeordnet werden und der Kühlkörper (20) auf der oberen Seite des Elementes (3). Die Kavität (18) wird auch in diesem Fall üblicherweise und zumindest stückweise bis zum Element (3) ausgebildet, so dass ein möglichst guter thermischer Kontakt gegeben ist.

### Bezugszeichenliste

- 1: Multifunktionelle Leiterplatte mit zumindest einem funktionalen Element
- 2: Substrat: Basismaterial z.B. FR-2, FR-3, FR-4, FR-4-Low-Tg, CEM-1, CEM-x, Pl, CE, Aramid, usw. bzw. Prepreg
- 3: Funktionales Element: rund oder rechteckig bzw. bandförmig; Kupfer oder Aluminium oder elektrisch u/o thermisch gut leitfähig
- 4: Leiterbahnstruktur: z.B. geätztes Kupfer
- 5: Leiterbahnstruktur Unterseite
- 6: Intermetallische Verbindung: US- bzw. Reibschweißen
- 7: Substrat 2: z.B. Innenlage bzw. Kernlage
- 8: Substrat 3: z.B. Innenlage bzw. Kernlage
- 9: Substrat 4: z.B. Außenlage bzw. Prepreg
- 10: Leiterbahnstruktur innenliegend
- 11 1: Leiterbahnstruktur innenliegend
- 12: Leiterbahnstruktur außenliegend
- 13: Soldermaske bzw. Lötstoppmaske oben
- 14: Soldermaske bzw. Lötstoppmaske unten
- 15: Kavität oben
- 16: Bauteil
- 17: Thermische Kontaktierung (inkl. mechanischer Befestigung/Montage)
- 18: Kavität unten
- 19: Vergußmasse
- 20: Kühlkörper
- 21: Durchkontaktierung bzw. Durchsteigeloch
- 22: Funktionales Element gekreuzt auf Kernlage
- 23: Funktionales Element gekreuzt auf Kupferfolie

## Patentansprüche

1. Multifunktionelle Leiterplatte- (1) mit einer elektrisch leitfähigen Struktur (4, 5, 10, 11, 12), wobei ein oder mehrere Hochstrom führende funktionelle Elemente (3, 22, 23) zumindest stückweise auf der elektrisch leitfähigen Struktur (4, 5, 10, 11, 12) mittels Ultraschall beziehungsweise Reibschweißen mechanisch und elektrisch leitend befestigt ist-, **dadurch gekennzeichnet, dass** das funktionelle Element (3, 22, 23) als thermisches Kontaktelement für ein Bauteil (16) ausgebildet ist, wobei der stückweise Kontakt (6) zwischen dem Element (3,22. 23) und der Struktur (4, 10, 11, 12) intermetallisch und flächig ausgebildet ist.

2. Multifunktionelle Leiterplatte nach Anspruch 1, **dadurch gekennzeichnet, dass** das funktionelle Element (3, 22, 23) aus Kupfer oder Aluminium ist und runden oder rechteckigen beziehungsweise abgerundeten Querschnitt aufweist.

3. Multifunktionelle Leiterplatte (1) nach einem der Ansprüche 1 bis 2, **dadurch gekennzeichnet, dass** das funktionelle Element (3, 22, 23) aus Kupfer oder Aluminium ist und mit einer elektrisch leitenden und/oder isolierenden Oberflächenbeschichtung versehen ist.

4. Multifunktionelle Leiterplatte (1) nach einem der Ansprüche 1 bis 3, **dadurch gekennzeichnet, dass** das funktionelle Element (3, 22, 23) aus Kupfer oder Aluminium ist und die Oberfläche galvanisch oder chemisch mit zumindest einer zusätzlichen Schicht versehen ist.

5. Multifunktionelle Leiterplatte (1) nach einem der Ansprüche 1 bis 4, **dadurch gekennzeichnet, dass** das funktionelle Element (3, 22, 23) aus Kupfer oder Aluminium ist und die Oberfläche zumindest stückweise ' lackisoliert ist.

6. Multifunktionelle Leiterplatte (1) nach einem der Ansprüche 1 bis 5, **dadurch gekennzeichnet, dass** das funktionelle Element (3, 22, 23) aus Kupfer oder Aluminium ist und die Oberfläche zumindest stückweise lackisoliert ist und derart elektrisch leitfähige Strukturen (4, 5, 10, 11, 12) ohne elektrische Kontaktierung kreuzen können beziehungsweise dass die funktionellen Elemente (3, 22, 23) miteinander gekreuzt werden können ohne elektrische Kontaktierung.

7. Multifunktionelle Leiterplatte (1) nach Anspruch 6, **dadurch gekennzeichnet, dass** das funktionelle Element (3, 22, 23) aus Kupfer oder Aluminium ist und die Lackisolation zumindest im Bereich der Verbindungen (6) mechanisch oder thermisch oder chemisch mittels Schleifen oder Bürsten oder Flämmen oder Plasmabehandlung oder UV-Laserbestrahlung oder Behandlung mit einem Lösemittel entfernt ist.

8. Multifunktionelle Leiterplatte (1) nach einem der Ansprüche 1 bis 7, **dadurch gekennzeichnet, dass** das funktionelle Element (3, 22,-23) in der Lage ist Ströme bis zu 100 Ampere zu leiten.

9. Multifunktionelle Leiterplatte (1) nach einem der Ansprüche 1 bis 8, **dadurch gekennzeichnet, dass** die Leiterplatte (1) als starre oder semiflexible oder starr-flexible Leiterplatte ausgebildet ist.

10. Multifunktionelle Leiterplatte (1) nach einem der Ansprüche 1 bis 9, **dadurch gekennzeichnet, dass** die Leiterplatte (1) als einseitige oder zweiseitige Leiterplatte oder als Multilayer-Leiterplatte ausgebildet ist.

11. Multifunktionelle Leiterplatte (1) nach einem der Ansprüche 1 bis 10, **dadurch gekennzeichnet, dass** das funktionelle Element (3, 22, 23) als thermisches Kontaktelement für einen Bauteil (16) ausgebildet ist und von der Unterseite oder der Oberseite oder von beiden Seiten freigefräst ist und auf einer Seite das Bauteil (16) und auf der anderen Seite der Kühlkörper (20) thermisch gut leitend kontaktiert ist und die entsprechende Kavität (15, 18) zumindest punktuell bis zu dem zumindest einen funktionellen Element (3, 22, 23) gefertigt ist.

12. Verfahren zur Herstellung einer multifunktionellen Leiterplatte (1) nach einem der Ansprüche 1 bis 11, wobei zuerst eine ätztechnische Leiterbahnstruktur (4, 5, 10, 11, 12) hergestellt wird und anschließend zumindest ein funktionelles Element (3, 22, 23) mittels Reibschweißen beziehungsweise Ultraschallschweißen (US-Schweißen) zumindest stückweise mit der Oberfläche eines Leiterbahnelementes (4, 5, 10, 11, 12) elektrisch leitfähig flächig kontaktiert wird, **dadurch gekennzeichnet, dass** zumindest ein funktionelles Element (3, 22, 23) mittels Reibschweißen beziehungsweise Ultraschallschweißen (US-Schweißen) zumindest stückweise auf der Oberfläche einer noch nicht strukturierten Kupferfolie elektrisch leitfähig flächig kontaktiert wird und anschließend in einer Laminierpresse nach dem Stand der Technik zu einer Leiterplatte beziehungsweise zu einem Prepreg verpresst wird und die Kupferfolie anschließend mit Strukturen (4, 5, 10, 11, 12) versehen wird.

13. Verfahren zur Herstellung einer multifunktionellen Leiterplatte (1) nach Anspruch 11 und 12, **dadurch gekennzeichnet, dass** die Oberflächen (3, 22, 23, 4, 5, 10, 11, 12) mittels der Reibschweiß- beziehungsweise Ultraschall-Verbindungsparameter eine intermetallische Verbindung mit elektrisch und thermisch leitfähiger und mechanisch flächiger Kontaktstelle (6) ausbilden.

14. Anwendung einer multifunktionellen Leiterplatte (1) nach einem der Ansprüche 1 bis 11 als Verdrahtungselement, das auf zumindest einer Verdrahtungsebene eine Schaltung mit der Möglichkeit der Leitung hoher Ströme vereint.

15. Anwendung einer multifunktionellen Leiterplatte (1) nach einem der Ansprüche 1 bis 11 als Verdrahtungselement, das durch die Integration von zumindest einem funktionellen Element (3, 22, 23) die Wärmeableitung eines darauf montierten Bauelementes (16) erhöht.

## Claims

1. Multifunctional printed circuit board (1), comprising an electrically conductive structure (4, 5, 10, 11, 12), wherein one or more high current carrying functional elements (3, 22, 23) is mechanically and electrically conductively fastened at least piece-wise to the electrically conductive structure (4, 5, 10, 11, 12) by means of ultrasound or friction welding, **characterised in that** the functional element (3, 22, 23) is configured as a thermal contact element for a component (16), the piece-wise contact (6) between the element (3, 22, 23) and the structure (4, 10, 11, 12) being configured in an intermetallic and planar manner.

2. Multifunctional printed circuit board according to claim 1, **characterised in that** the functional element (3, 22, 23) is made of copper or aluminium and has a round or rectangular or rounded cross section.

3. Multifunctional printed circuit board (1) according to either of claims 1 or 2, **characterised in that** the functional element (3, 22, 23) is made of copper or aluminium and is provided with an electrically conductive and/or insulating surface coating.

4. Multifunctional printed circuit board (1) according to any one of claims 1 to 3, **characterised in that** the functional element (3, 22, 23) is made of copper or aluminium and the surface is provided by electro-plating or chemically with at least one additional layer.

5. Multifunctional printed circuit board (1) according to any one of claims 1 to 4, **characterised in that** the functional element (3, 22, 23) is made of copper or aluminium and the surface is varnish-insulated, at least piece-wise.

6. Multifunctional printed circuit board (1) according to any one of claims 1 to 5, **characterised in that** the functional element (3, 22, 23) is made of copper or aluminium and the surface is varnish-insulated at least piece-wise and electrically conductive structures (4, 5, 10, 11, 12) of this type may cross without electrical contacting or **in that** the functional elements (3, 22, 23) may be crossed with one another without electrical contacting.

7. Multifunctional printed circuit board (1) according to claim 6, **characterised in that** the functional element (3, 22, 23) is made of copper or aluminium and the varnish insulation is mechanically or thermally or chemically removed at least in the region of the connections (6) by means of grinding or brushing or flame scarfing or plasma treatment or UV laser radiation or treatment with a solvent.

8. Multifunctional printed circuit board (1) according to any one of claims 1 to 7, **characterised in that** the functional element (3, 22, 23) is in a position to conduct currents up to 100 amperes.

9. Multifunctional printed circuit board (1) according to any one of claims 1 to 8, **characterised in that** the printed circuit board (1) is configured as a rigid or semi-flexible or rigid-flexible printed circuit board.

10. Multifunctional printed circuit board (1) according to any one of claims 1 to 9, **characterised in that** the printed circuit board (1) is configured as a one-sided or two-sided printed circuit board or as a multi-layer printed circuit board,

11. Multifunctional printed circuit board (1) according to any one of claims 1 to 10, **characterised in that** the functional element (3, 22, 23) is configured as a thermal contact element for a component (16) and is milled free from the lower side or the upper side or from both sides and, on one side, the component (16) and, on the other side, the heat sink (20) is thermally contacted with good conductivity and the corresponding cavity (15, 18) is produced at least at points up to the at least one functional element (3, 22, 23).

12. Method for producing a multifunctional printed circuit board (1) according to any one of claims 1 to 11, wherein an etched printed circuit board structure (4, 5, 10, 11, 12) is firstly produced and then at least one functional element (3, 22, 23) is contacted in an electrically conductive planar manner by means of friction welding or ultrasound welding (US welding) at least piece-wise with the surface of a printed circuit board element (4, 5, 10, 11, 12), **characterised in that** at least one functional element (3, 22, 23) is contacted in an electrically conductive planar manner by means of friction welding or ultrasound welding (US welding) at least piece-wise on the surface of a not yet structured copper foil and is then pressed to form a printed circuit board or a prepreg in a laminating press according to the state of the art and the copper foil is then provided with structures (4, 5, 10, 11, 12).

13. Method for producing a multifunctional printed circuit board (1) according to claim 11 and 12, **characterised in that** the surfaces (3, 22, 23, 4, 5, 10, 11, 12), by means of the friction welding or ultrasound connecting parameters, form an intermetallic connection to an electrically and thermally conductive and mechanically planar contact point (6).

14. Application of a multifunctional printed circuit board (1) according to any one of claims 1 to 11 as a wiring element, which, at least on one wiring plane, combines a circuit with the possibility of the conduction of high currents.

15. Application of a multifunctional printed circuit board (1) according to any one of claims 1 to 11 as a wiring element, which increases the heat dissipation of a component (16) assembled thereon by the integration of at least one functional element (3, 22, 23).

## Revendications

1. Carte de circuits imprimés multifonctionnelle (1) avec une structure conductrice d'électricité (4, 5, 10, 11, 12), un ou plusieurs éléments fonctionnels conducteurs de courant élevé (3, 22, 23) étant fixés au moins en partie sur la structure conductrice d'électricité (4, 5, 10, 11, 12), mécaniquement et avec une conductibilité électrique, à l'aide d'ultrasons ou par soudage par friction, **caractérisée en ce que** l'élément fonctionnel (3, 22, 23) est conçu comme un élément de contact thermique pour un composant (16), le contact partiel (6) entre l'élément (3, 22, 23) et la structure (4, 10, 11, 12) étant intermétallique et plan.

2. Carte de circuits imprimés multifonctionnelle (1) selon la revendication 1, **caractérisée en ce que** l'élément fonctionnel (3, 22, 23) est en cuivre ou en aluminium et présente une section transversale ronde ou rectangulaire ou arrondie.

3. Carte de circuits imprimés multifonctionnelle (1) selon l'une des revendications 1 à 2, **caractérisée en ce que** l'élément fonctionnel (3, 22, 23) est en cuivre ou en aluminium et est pourvu d'un revêtement de surface conducteur d'électricité et/ou isolant.

4. Carte de circuits imprimés multifonctionnelle (1) selon l'une des revendications 1 à 3, **caractérisée en ce que** l'élément fonctionnel (3, 22, 23) est en cuivre ou en aluminium et la surface est pourvue d'au moins une couche supplémentaire par voie galvanique ou chimique.

5. Carte de circuits imprimés multifonctionnelle (1) selon l'une des revendications 1 à 4, **caractérisée en ce que** l'élément fonctionnel (3, 22, 23) est en cuivre ou en aluminium et la surface est pourvue au moins en partie d'une isolation vernissée.

6. Carte de circuits imprimés multifonctionnelle (1) selon l'une des revendications 1 à 5, **caractérisée en ce que** l'élément fonctionnel (3, 22, 23) est en cuivre ou en aluminium et la surface est pourvue au moins en partie d'une isolation vernissée et de telles structures conductrices d'électricité (4, 5, 10, 11, 12) peuvent se croiser sans connexion électrique ou que les éléments fonctionnels (3, 22, 23) peuvent se croiser sans connexion électrique.

7. Carte de circuits imprimés multifonctionnelle (1) selon la revendication 6, **caractérisée en ce que** l'élément fonctionnel (3, 22, 23) est en cuivre ou en aluminium et l'isolation vernissée est enlevée au moins dans la zone des liaisons (6), mécaniquement ou thermiquement ou chimiquement par ponçage ou brossage ou passage à la flamme ou traitement au plasma ou rayons UV ou traitement à l'aide d'un solvant.

8. Carte de circuits imprimés multifonctionnelle (1) selon l'une des revendications 1 à 7, **caractérisée en ce que** l'élément fonctionnel (3, 22, 23) est en mesure de transmettre des courants allant jusqu'à 100 ampères.

9. Carte de circuits imprimés multifonctionnelle (1) selon l'une des revendications 1 à 8, **caractérisée en ce qu'**elle est conçue comme une carte rigide ou semiflexible ou rigide-flexible.

10. Carte de circuits imprimés multifonctionnelle (1) selon l'une des revendications 1 à 9, **caractérisée en ce qu'**elle est conçue comme une carte de circuits imprimés unilatérale ou bilatérale ou comme une carte de circuits imprimés multicouche.

11. Carte de circuits imprimés multifonctionnelle (1) selon l'une des revendications 1 à 10, **caractérisée en ce que** l'élément fonctionnel (3, 22, 23) est conçu comme un élément de contact thermique pour un composant (16) et est fraisé par la face inférieure ou par la face supérieure ou par les deux faces, et le composant (16) sur une face et le corps de refroidissement, (20) sur l'autre face sont connectés avec une bonne conduction thermique et la cavité correspondante (15, 18) est réalisée au moins ponctuellement jusqu'audit élément fonctionnel (3, 22, 23).

12. Procédé pour fabriquer une carte de circuits imprimés multifonctionnelle (1) selon l'une des revendications 1 à 11, selon lequel une structure de pistes conductrices (4, 5, 10, 11, 12) est tout d'abord fabriquée par gravure puis au moins un élément fonctionnel (3, 22, 23) est connecté à plat, de manière à transmettre le courant, au moins en partie sur la surface d'un élément formant piste conductrice (4, 5, 10, 11, 12), par soudage par friction ou par ultrasons, **caractérisé en ce qu'**au moins un élément fonctionnel (3, 22, 23) est connecté à plat, de manière à transmettre le courant, au moins en partie sur la surface d'une feuille de cuivre pas encore structurée, par soudage par friction ou par ultrasons, puis est pressé dans une presse de laminage de l'art antérieur pour former une carte de circuits imprimés ou un pré-imprégné, et la feuille de cuivre est ensuite pourvue de structures (4, 5, 10, 11, 12).

13. Procédé pour fabriquer une carte de circuits imprimés multifonctionnelle (1) selon les revendications 11 et 12, **caractérisé en ce que** les surfaces (3, 22, 23, 4, 5, 10, 11, 12) forment, à l'aide des paramètres de soudage par friction ou de liaison par ultrasons, une liaison intermétallique avec un point de contact (6) mécaniquement plan et conducteur d'électricité et de chaleur.

14. Application d'une carte de circuits imprimés multifonctionnelle (1) selon l'une des revendications 1 à 11 comme élément de câblage qui réunit un circuit sur au moins un plan de câblage avec la possibilité de la conduction de courants élevés.

15. Application d'une carte de circuits imprimés multifonctionnelle (1) selon l'une des revendications 1 à 11 comme élément de câblage qui, grâce à l'intégration d'au moins un élément fonctionnel (3, 22, 23), augmente la dissipation de chaleur d'un composant (16) monté dessus.
